# EUROPÄISCHE PATENTANMELDUNG

(11) **EP 4 465 460 A1**
(43) Veröffentlichungstag der Anmeldung: **20.11.2024**
(21) Anmeldenummer: 23174009.3
(22) Anmeldetag: 17.05.2023
(51) Int. Cl.: H02B 1/20

(54) **MONTAGEPLATTE FÜR EINEN SCHALTSCHRANK UND DEREN HERSTELLUNG**

(71) Anmelder: Siemens Aktiengesellschaft, 80333 München (DE)
(72) Erfinder: Jähnicke, Jens, 09112 Chemnitz (DE)
(74) Vertreter: Siemens Patent Attorneys

(57) **Zusammenfassung**

Die Erfindung betrifft eine Montageplatte (1) für einen Schaltschrank (19) und ein Verfahren zu deren Herstellung. Die Montageplatte (1) umfasst eine Trägerplatte (3), eine auf die Trägerplatte (3) aufgebrachte elektrisch isolierende keramische Funktionsschicht (5) und auf die Funktionsschicht (5) gedruckte elektrische Leiter (7, 9).

## Beschreibung

Die Erfindung betrifft eine Montageplatte für einen Schaltschrank und ein Verfahren zu deren Herstellung.

In einem Schaltschrank werden elektrische Bauelemente einer technischen Vorrichtung oder Anlage angeordnet. Derartige elektrische Bauelemente sind beispielsweise Schütze, Schalter, Steuerungseinheiten oder Eingabe-/Ausgabeeinheiten. In herkömmlichen Schaltschränken werden elektrische Bauelemente in der Regel durch Kabel elektrisch verbunden. Bei einer Vielzahl elektrischer Bauelemente entsteht dabei ein hoher Verkabelungsaufwand. Die Verkabelung der elektrischen Bauelemente ist ein manueller, personalintensiver und dadurch auch kostspieliger Prozess.

Der Erfindung liegt die Aufgabe zugrunde, den Aufwand zum elektrischen Verbinden elektrischer Bauelemente eines Schaltschranks zu reduzieren.

Die Aufgabe wird erfindungsgemäß durch eine Montageplatte für einen Schaltschrank mit den Merkmalen des Anspruchs 1, ein Verfahren zur Herstellung der Montageplatte mit den Merkmalen des Anspruchs 11 und einen Schaltschrank mit den Merkmalen des Anspruchs 15 gelöst.

Vorteilhafte Ausgestaltungen der Erfindung sind Gegenstand der Unteransprüche.

Eine erfindungsgemäße Montageplatte für einen Schaltschrank umfasst
- eine Trägerplatte,
- eine auf die Trägerplatte aufgebrachte elektrisch isolierende keramische Funktionsschicht und
- auf die Funktionsschicht gedruckte elektrische Leiter.

Eine erfindungsgemäße Montageplatte für einen Schaltschrank weist also Leiter auf, die auf eine Funktionsschicht gedruckt werden, wobei die Funktionsschicht aus einem elektrisch isolierenden keramischen Material gefertigt ist, das auf eine Trägerplatte aufgebracht ist. Der Druckprozess ist dabei ein Prozess der Materialextrusion. Die auf die Funktionsschicht gedruckten Leiter ersetzen Kabel, mit denen üblicherweise elektrische Bauelemente des Schaltschranks verbunden werden. Dadurch wird der Verkabelungsaufwand zum Verkabeln der elektrischen Bauelemente vorteilhaft reduziert. Außerdem ermöglicht das Drucken der Leiter gegenüber einer Verkabelung eine bessere Qualitätskontrolle, eine bessere Entwärmung der elektrischen Bauelemente und Leiter durch die Funktionsschicht sowie eine Materialeinsparung für die Herstellung der Leiter.

Bei einer Ausgestaltung der erfindungsgemäßen Montageplatte ist die Funktionsschicht aus Chromoxid gefertigt. Chromoxid eignet sich besonders als Material der Funktionsschicht, da es Laserstrahlung gut absorbiert, mit der die Funktionsschicht gemäß dem erfindungsgemäßen Verfahren zur Herstellung der Montageplatte vor dem Bedrucken mit den Leitern aufgeschmolzen wird (siehe unten).

Bei einer weiteren Ausgestaltung der erfindungsgemäßen Montageplatte ist in jedem Kreuzungsbereich, in dem sich zwei Leiter kreuzen, zwischen die beiden Leiter eine elektrisch isolierende keramische Trennschicht gedruckt, die die Leiter voneinander elektrisch isoliert. Die Trennschicht ist beispielsweise aus einem Glas gefertigt. Die Trennschicht wird also ebenfalls durch Materialextrusion aufgetragen (gedruckt), so dass die Kreuzungsbereiche der Leiter mit demselben Fertigungsverfahren wie die Leiter hergestellt werden.

Bei einer weiteren Ausgestaltung der erfindungsgemäßen Montageplatte ist die mit den elektrischen Leitern bedruckte Funktionsschicht mit einem Lack versiegelt. Dadurch werden die Leiter und die Funktionsschicht vorteilhaft vor Umgebungseinflüssen geschützt.

Bei einer weiteren Ausgestaltung der erfindungsgemäßen Montageplatte ist die Trägerplatte ein Trägerblech. Das Trägerblech stabilisiert vorteilhaft die Montageplatte und ermöglicht, dass an der Montageplatte massereiche elektrische Bauelemente angeordnet werden und die Montageplatte auch den Schaltschrank stabilisiert.

Bei einer zur vorgenannten Ausgestaltung alternativen Ausgestaltung der erfindungsgemäßen Montageplatte ist die Trägerplatte ein Trägerblech mit einer auf das Trägerblech aufgebrachten elektrisch isolierenden keramischen Isolationsschicht, auf die die Funktionsschicht aufgebracht ist. Die Isolationsschicht ist vorzugsweise aus einem Material gefertigt, das eine höhere Schmelztemperatur als die Funktionsschicht aufweist. Beispielsweise ist die Isolationsschicht aus Aluminiumoxid gefertigt. Bei dieser Ausgestaltung der erfindungsgemäßen Montageplatte weist die Montageplatte also eine elektrisch isolierende keramische Isolationsschicht auf, die zwischen dem Trägerblech und der Funktionsschicht angeordnet ist. Dadurch kann die Dicke der Funktionsschicht vorteilhaft reduziert werden, da ihre isolierende Wirkung zum Teil von der Isolationsschicht übernommen wird. Die Fertigung der Isolationsschicht aus einem Material, das eine höhere Schmelztemperatur, insbesondere deutlich höhere Schmelztemperatur als die Funktionsschicht aufweist, ist vorteilhaft, da dadurch verhindert werden kann, dass die Isolationsschicht von Laserstrahlung aufgeschmolzen wird, mit der die Funktionsschicht gemäß dem erfindungsgemäßen Verfahren zur Herstellung der Montageplatte vor dem Drucken der Leiter aufgeschmolzen wird.

Bei dem erfindungsgemäßen Verfahren zur Herstellung einer erfindungsgemäßen Montageplatte werden die elektrischen Leiter auf die Funktionsschicht gedruckt, indem die mit den elektrischen Leitern zu bedruckenden Bereiche der Funktionsschicht durch Laserstrahlung zunächst aufgeschmolzen werden und anschließend auf die aufgeschmolzenen Bereiche geschmolzenes Leitermaterial gedruckt wird. Das Aufschmelzen der mit den elektrischen Leitern zu bedruckenden Bereiche der Funktionsschicht vor dem Bedrucken dieser Bereiche mit dem Leitermaterial verbessert vorteilhaft die Einkopplung des Leitermaterials in die Funktionsschicht und damit die Anhaftung der Leiter an der Funktionsschicht. Die Verwendung von Laserstrahlung zum Aufschmelzen der mit den elektrischen Leitern zu bedruckenden Bereiche der Funktionsschicht ermöglicht vorteilhaft ein Aufschmelzen der Funktionsschicht, das lokal auf die zu bedruckenden Bereiche der Funktionsschicht begrenzt ist.

Bei einer Ausgestaltung des erfindungsgemäßen Verfahrens wird die Funktionsschicht durch thermisches Spritzen auf die Trägerplatte aufgebracht. Dies ermöglicht vorteilhaft ein preiswertes Aufbringen der Funktionsschicht auf die Trägerplatte.

Bei einer weiteren Ausgestaltung des erfindungsgemäßen Verfahrens wird in jedem Kreuzungsbereich, in dem sich zwei Leiter kreuzen, zunächst ein erster Leiter auf die Funktionsschicht gedruckt, anschließend wird die Trennschicht auf den ersten Leiter und die Funktionsschicht gedruckt und abschließend wird der zweite Leiter auf die Trennschicht gedruckt. Dies ermöglicht vorteilhaft die oben bereits genannte Herstellung auch der Kreuzungsbereiche der Leiter mit demselben Verfahren wie die Herstellung der Leiter selbst.

Bei einer weiteren Ausgestaltung des erfindungsgemäßen Verfahrens zur Herstellung einer Montageplatte, die ein Trägerblech mit einer auf das Trägerblech aufgebrachten elektrisch isolierenden keramischen Isolationsschicht aufweist, wird die Isolationsschicht durch thermisches Spritzen auf das Trägerblech aufgebracht. Dies ermöglicht vorteilhaft ein preiswertes Aufbringen der Isolationsschicht auf das Trägerblech.

Die Dicke des Trägerbleches richtet sich nach den mechanischen Erfordernissen bezüglich der Stabilität der Montageplatte und beträgt beispielsweise etwa 2 mm. Die Dicken der Isolationsschicht und der Funktionsschicht ergeben sich aus Materialkonstanten dieser Schichten und deren erforderlichen Durchschlagsfestigkeiten und betragen beispielsweise etwa 100 µm.

Ein erfindungsgemäßer Schaltschrank weist eine erfindungsgemäße Montageplatte auf. Die Vorteile eines erfindungsgemäßen Schaltschranks entsprechen den oben genannten Vorteilen einer erfindungsgemäßen Montageplatte.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung von Ausführungsbeispielen, die im Zusammenhang mit den Zeichnungen näher erläutert werden. Dabei zeigen:
FIG 1 eine perspektivische Darstellung eines Ausführungsbeispiels einer Montageplatte für einen Schaltschrank,
FIG 2 eine perspektivische Darstellung eines Ausführungsbeispiels einer Montageplatte für einen Schaltschrank während deren Herstellung,
FIG 3 eine perspektivische Darstellung eines Ausführungsbeispiels eines Schaltschranks.

Einander entsprechende Teile sind in den Figuren mit denselben Bezugszeichen versehen.

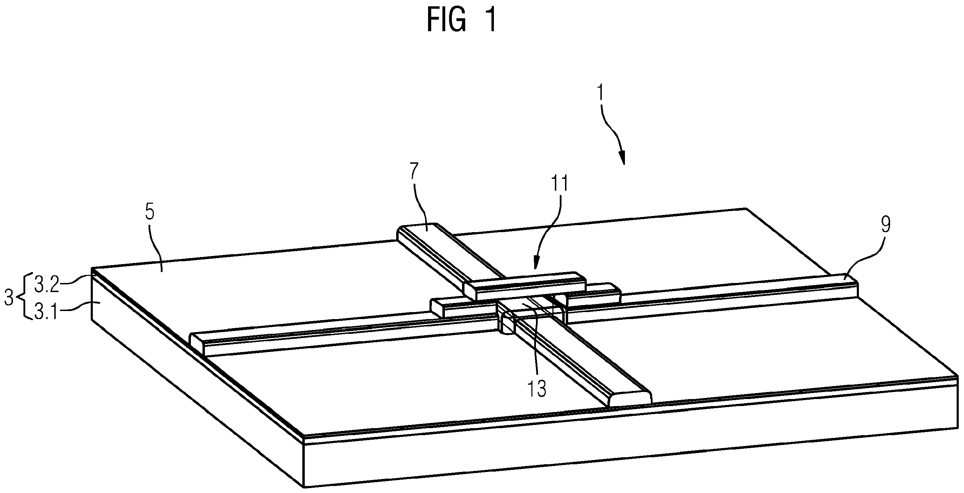

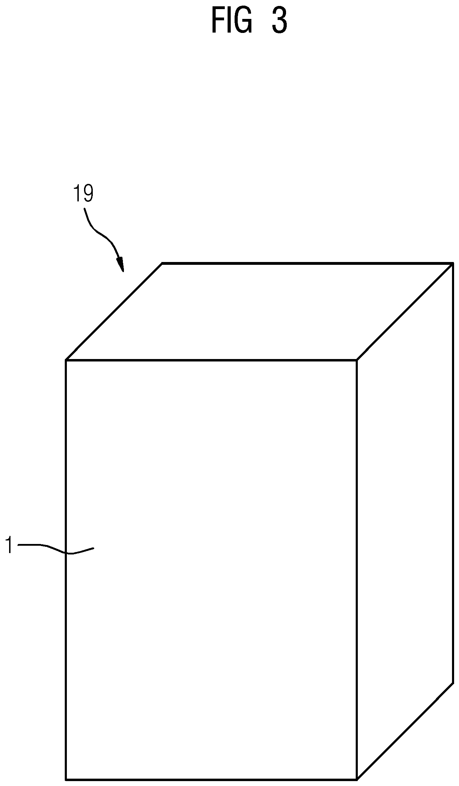

Figur 1 (FIG 1) zeigt eine perspektivische Darstellung eines Ausführungsbeispiels einer Montageplatte 1 für einen Schaltschrank 19 (siehe Figur 3).

Die Montageplatte 1 umfasst eine Trägerplatte 3, eine auf die Trägerplatte 3 aufgebrachte elektrisch isolierende keramische Funktionsschicht 5 und auf die Funktionsschicht 5 gedruckte elektrische Leiter 7, 9.

Die Funktionsschicht 5 ist beispielsweise aus Chromoxid gefertigt.

Die Trägerplatte 3 ist ein Trägerblech 3.1 mit einer auf das Trägerblech 3.1 aufgebrachten elektrisch isolierenden keramischen Isolationsschicht 3.2, auf die die Funktionsschicht 5 aufgebracht ist. Das Trägerblech 3.1 ist beispielsweise aus einem Stahl gefertigt. Die Isolationsschicht 3.2 ist aus einem Material gefertigt, das eine deutlich höhere Schmelztemperatur als die Funktionsschicht 5 aufweist. Beispielsweise ist die Isolationsschicht 3.2 aus Aluminiumoxid gefertigt.

In dem in Figur 1 gezeigten Ausführungsbeispiel weist die Montageplatte 1 zwei sich in einem Kreuzungsbereich 11 kreuzende Leiter 7, 9 auf. In dem Kreuzungsbereich 11 ist zwischen die beiden Leiter 7, 9 eine elektrisch isolierende keramische Trennschicht 13 gedruckt, die die Leiter 7, 9 voneinander elektrisch isoliert. Die Trennschicht 13 ist beispielsweise aus einem Glas gefertigt.

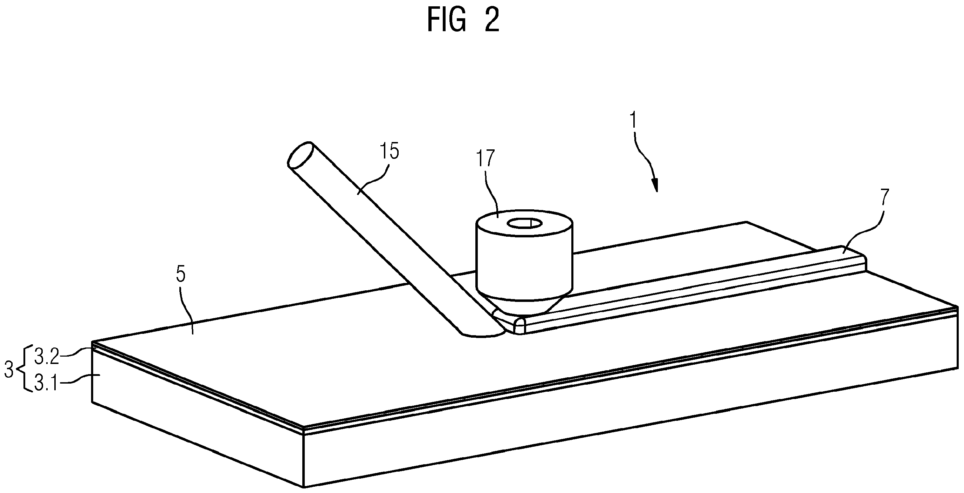

Figur 2 (FIG 2) zeigt eine perspektivische Darstellung eines Ausführungsbeispiels einer Montageplatte 1 für einen Schaltschrank 19 während deren Herstellung.

Die Montageplatte 1 umfasst eine Trägerplatte 3, eine auf die Trägerplatte 3 aufgebrachte elektrisch isolierende keramische Funktionsschicht 5 und einen auf die Funktionsschicht 5 gedruckten elektrischen Leiter 7.

Wie in dem in Figur 1 gezeigten Ausführungsbeispiel ist die Trägerplatte 3 ein Trägerblech 3.1 mit einer auf das Trägerblech 3.1 aufgebrachten elektrisch isolierenden keramischen Isolationsschicht 3.2, auf die die Funktionsschicht 5 aufgebracht ist. Das Trägerblech 3.1 wird beispielsweise aus einem Stahl gefertigt. Die Isolationsschicht 3.2 ist aus einem Material gefertigt, das eine deutlich höhere Schmelztemperatur als die Funktionsschicht 5 aufweist. Die Isolationsschicht 3.2 ist beispielsweise aus Aluminiumoxid gefertigt und wird durch thermisches Spritzen auf das Trägerblech 3.1 aufgebracht. Die Funktionsschicht 5 ist beispielsweise aus Chromoxid gefertigt und wird durch thermisches Spritzen auf die Isolationsschicht 3.2 aufgebracht.

Der Leiter 7 wird auf die Funktionsschicht 5 gedruckt, indem die mit dem Leiter 7 zu bedruckenden Bereiche der Funktionsschicht 5 durch Laserstrahlung 15 zunächst aufgeschmolzen werden und anschließend auf die aufgeschmolzenen Bereiche geschmolzenes Leitermaterial gedruckt wird, das von einer Düse 17 auf die aufgeschmolzenen Bereiche ausgegeben wird.

Zur Herstellung eines in Figur 1 gezeigten Kreuzungsbereiches 11, in dem sich zwei Leiter 7, 9 kreuzen, wird in dem Kreuzungsbereich 11 zunächst ein erster Leiter 7 auf die Funktionsschicht 5 gedruckt. Anschließend wird die Trennschicht 13 auf den ersten Leiter 7 und die Funktionsschicht 5 gedruckt. Danach wird der zweite Leiter 9 auf die Trennschicht 5 gedruckt.

Abschließend wird die mit den elektrischen Leitern 7, 9 bedruckte Funktionsschicht 5 mit einem Lack versiegelt.

Figur 3 (FIG 3) zeigt eine perspektivische Darstellung eines Ausführungsbeispiels eines Schaltschranks 19. Der Schaltschrank 19 weist eine anhand der Figuren 1 und 2 beschriebene Montagewand 1 auf, die eine Rückwand des Schaltschranks 19 bildet.

Obwohl die Erfindung im Detail durch bevorzugte Ausführungsbeispiele näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

Unabhängig vom grammatikalischen Geschlecht eines bestimmten Begriffs sind Personen mit männlicher, weiblicher oder anderer Geschlechteridentität mit umfasst.

## Patentansprüche

1. Montageplatte (1) für einen Schaltschrank (19), die Montageplatte (1) umfassend
- eine Trägerplatte (3),
- eine auf die Trägerplatte (3) aufgebrachte elektrisch isolierende keramische Funktionsschicht (5) und
- auf die Funktionsschicht (5) gedruckte elektrische Leiter (7, 9) .

2. Montageplatte (1) nach Anspruch 1, wobei die Funktionsschicht (5) aus Chromoxid gefertigt ist.

3. Montageplatte (1) nach Anspruch 1 oder 2, wobei in jedem Kreuzungsbereich (11), in dem sich zwei Leiter (7, 9) kreuzen, zwischen die beiden Leiter (7, 9) eine elektrisch isolierende keramische Trennschicht (13) gedruckt ist, die die Leiter (7, 9) voneinander elektrisch isoliert.

4. Montageplatte (1) nach Anspruch 3, wobei die Trennschicht (13) aus einem Glas gefertigt ist.

5. Montageplatte (1) nach einem der vorhergehenden Ansprüche, wobei die mit den elektrischen Leitern (7, 9) bedruckte Funktionsschicht (5) mit einem Lack versiegelt ist.

6. Montageplatte (1) nach einem der vorhergehenden Ansprüche, wobei die Trägerplatte (3) ein Trägerblech (3.1) ist.

7. Montageplatte (1) nach einem der Ansprüche 1 bis 5, wobei die Trägerplatte (3) ein Trägerblech (3.1) mit einer auf das Trägerblech (3.1) aufgebrachten elektrisch isolierenden keramischen Isolationsschicht (3.2) ist, auf die die Funktionsschicht (5) aufgebracht ist.

8. Montageplatte (1) nach Anspruch 7, wobei die Isolationsschicht (3.2) aus einem Material gefertigt ist, das eine höhere Schmelztemperatur als die Funktionsschicht (5) aufweist.

9. Montageplatte (1) nach Anspruch 7 oder 8, wobei die Isolationsschicht (3.2) aus Aluminiumoxid gefertigt ist.

10. Montageplatte (1) nach einem der Ansprüche 6 bis 9, wobei das Trägerblech (3.1) aus einem Stahl gefertigt ist.

11. Verfahren zur Herstellung einer gemäß einem der vorhergehenden Ansprüche ausgebildeten Montageplatte (1), wobei die elektrischen Leiter (7, 9) auf die Funktionsschicht (5) gedruckt werden, indem die mit den elektrischen Leitern (7, 9) zu bedruckenden Bereiche der Funktionsschicht (5) durch Laserstrahlung (15) zunächst aufgeschmolzen werden und anschließend auf die aufgeschmolzenen Bereiche geschmolzenes Leitermaterial gedruckt wird.

12. Verfahren nach Anspruch 11, wobei die Funktionsschicht (5) durch thermisches Spritzen auf die Trägerplatte (3) aufgebracht wird.

13. Verfahren nach Anspruch 11 oder 12 zur Herstellung einer gemäß Anspruch 3 oder 4 ausgebildeten Montageplatte (1), wobei in jedem Kreuzungsbereich (11) zweier Leiter (7, 9) zunächst ein erster Leiter (7) auf die Funktionsschicht (5) gedruckt wird, anschließend die Trennschicht (13) auf den ersten Leiter (7) und die Funktionsschicht (5) gedruckt wird und abschließend der zweite Leiter (9) auf die Trennschicht (13) gedruckt wird.

14. Verfahren nach einem der Ansprüche 11 bis 13 zur Herstellung einer gemäß einem der Ansprüche 7 bis 9 ausgebildeten Montageplatte (1), wobei die Isolationsschicht (3.2) durch thermisches Spritzen auf das Trägerblech (3.1) aufgebracht wird.

15. Schaltschrank (19) mit einer Montageplatte (1) nach einem der Ansprüche 1 bis 10.
